# EUROPÄISCHE PATENTSCHRIFT

(11) **EP 1 387 392 B1**
(45) Veröffentlichungstag und Bekanntmachung des Hinweises auf die Patenterteilung: **24.04.2013**
(21) Anmeldenummer: 03000853.6
(22) Anmeldetag: 15.01.2003
(51) Int. Cl.: H01L 21/683

(54) **Elektrostatischer Greifer**
Electrostatic gripper
Pince de préhension électrostatique

(30) Priorität: 15.07.2002 DE 10232080
(43) Veröffentlichungstag der Anmeldung: 04.02.2004
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- US-A- 5 880 924
- US-A- 6 023 405
- US-A- 6 122 159
- US-B1- 6 185 085
- US-B1- 6 272 002
- US-B1- 6 351 367
- US-B1- 6 354 791
- PATENT ABSTRACTS OF JAPAN Bd. 2000, Nr. 04, 31. August 2000 (2000-08-31) -& JP 2000 012666 A (TAIHEIYO CEMENT CORP), 14. Januar 2000 (2000-01-14)
- PATENT ABSTRACTS OF JAPAN Bd. 1996, Nr. 03, 29. März 1996 (1996-03-29) -& JP 07 297265 A (SHIN ETSU CHEM CO LTD), 10. November 1995 (1995-11-10)

## Beschreibung

Die Erfindung betrifft einen auf elektrostatischem Prinzip arbeitenden Greifer, insbesondere zur Anwendung in der Halbleiterindustrie.

Zum Greifen von Wafern werden zum einen mechanische Greifer eingesetzt. Diese Technik ist vor allem bei kleinen Bauteilen sehr aufwendig und kann zu Beschädigungen und Verunreinigungen des Wafers führen.

Als Alternative werden Vakuumgreifer eingesetzt, die durch Unterdruck den Wafer ansaugen und so transportieren können. Durch die in der Halbleiterindustrie fortschreitende Verkleinerung der Strukturen wird aber immer mehr in einer Vakuumumgebung produziert. Hier sind Vakuumgreifer naturgemäß nicht einsetzbar.

Andere Greifer arbeiten auf dem Prinzip der elektrostatischen Anziehung.

Dabei kann eine Spannung an den Wafer und eine entgegensetzte Spannung an den Greifer gelegt werden. Aufgrund der elektrostatischen Anziehungskraft kann der Wafer dann angehoben und bewegt werden. Nachteilig an diesem Prinzip ist, dass der Wafer zur Anlegung der Spannung elektrisch leitend sein muss. Zum Greifen von nicht leitenden (dielektrischen) Wafern gibt es daher elektrostatische Greifer, die, wie der erfindungsgemäße Greifer, nebeneinander angeordnete Elektroden aufweisen. Auch dieses Prinzip ist schon seit längerem Stand der Technik. So wird z.B. in US 4,184,188 (Briglia) und in US 4,399,016 (Tsukuda) ein auf diesem Prinzip arbeitender Greifer beschrieben.

Bei herkömmlichen Greifern wird als Isolierschicht meistens Aluminium(III)oxid verwendet (US 6 272 002 B1, US 6 122 159 A). Das Dokument US 6 272 002 B1 beschreibt zudem die Verwendung von Zirkoniumoxid als thermische Abschwächungsschicht sowie das Herstellen einer Elektrode durch Pressen und Sintern eines Schichtverbundes.

Um den Wafer zu heben, wird eine entgegengesetzte Spannung an jeweils nebeneinander liegende, entgegengesetzt gepolte Elektroden gelegt. Die Elektroden haben jetzt eine andere Ladung als das zu hebende Bauteil, was zu einer Kraft durch die elektrostatische Anziehung führt. Infolge dieser Kraft bleibt der Wafer am Greifer hängen und kann sodann bewegt werden. Um das Bauteil wieder abzusetzen, werden die Elektroden geerdet.

Ein Nachteil der bekannten Greifer dieses Prinzips ist, dass im Wafer durch die Spannungsdifferenzen ein Strom fließt, der von der Leitfähigkeit des Wafers und der Höhe der Spannung abhängt. Dieser Strom führt zu einer Erwärmung des Wafers, die von dessen Geometrie und Leitfähigkeit, sowie der angelegten Spannung abhängt. Infolge dieser Erwärmung kann es zu Verziehungen und Beschädigungen des Wafers kommen. Dieses Problem besteht infolge der fehlenden Konvektion besonders im Vakuum.

Weiteres Problem beim Einsatz eines elektrostatischen Greifers im Vakuum sind Änderungen in der Überschlagspannung, die zwar sowohl im Hochvakuum, als auch bei Atmosphärendruck über 2000V/mm liegt, bedingt durch die längere mittlere freie Weglänge aber dazwischen bis auf 6V/mm absinkt.

Weiterer Nachteil hoher Spannungen ist, dass durch das damit verbundene hohe Potential die Wafer von angezogenen Staubpartikeln etc. schnell verunreinigt werden. Aufgabe der Erfindung ist es, einen elektrostatischen Greifer zu entwickeln, der die Erwärmung des Wafers auf ein Mindestmaß reduziert und mit möglichst niedriger Spannung betrieben werden kann.

Gelöst wird diese Aufgabe mit einer Greifvorrichtung gemäß den Merkmalen nach Anspruch 1.

Vorteilhafte und bevorzugte Weiterbildungen sind den jeweils zugeordneten Unteransprüchen zu entnehmen.

Bei herkömmlichen Greifern wird als Isolierschicht meistens Aluminium(III)oxid verwendet. Nachteilig ist die niedrige relative Dielektizitätskonstante. Mit Zusätzen kann diese verbessert werden (beispielsweise Al 418 der Firma Toto). Nachteilig ist dann aber, dass das Material eine Dicke von etwa 1 mm hat, wodurch zum Erreichen einer gewünschten Dicke von etwa 100 µm aufwendige Schleifarbeiten nötig sind.

Das beim erfindungsgemäßen Greifer verwendete Zirkoniumoxid, das z.B. zur Produktion von Brennstoffzellen verwendet wird, ist in Schichtdicken von 50-300 µm verfügbar und muss daher nicht oder nur wenig geschliffen werden. Denkbar sind auch Schichtdicken unter 50 µm, die man durch Schleifen oder durch Aufbringen der Zirkoniumoxidschicht in einem CVD- oder sputtering-Verfahren erreicht. Auf letztere Weise sind Schichtdicken im Bereich weniger Atomdurchmesser möglich. Ein weiterer Vorteil ergibt sich aus der höheren Härte des Zirkoniumoxids gegenüber Aluminiumoxid. Sowohl bei der Herstellung, als auch im Betrieb wird die Schicht weniger schnell beschädigt. Die Schicht bleibt zudem glatt, wodurch Beschädigungen des Wafers auch nach längerem Einsatz vermieden werden. Weiterer Vorteil ist der sehr hohe spezifische elektrische Widerstand von ca. 10¹⁴ Ωm, weswegen die Schichtdicke sehr klein gehalten werden kann.

Infolge der kleinen Schichtdicken und der relativ hohen Dielelektrizitätskonstante kann der erfindungsgemäße Greifer mit einer Gleichspannung von nur 200 bis 900 V betrieben werden, was zu stark reduzierten Strömen im Wafer führt. Bekannte elektrostatische Greifer werden dagegen mit Spannungen zwischen 1 und 6 kV betrieben.

Der erfindungsgemäße Greifer weist ferner zwei oder mehr Elektrodenpaare auf, die auf einer Schaltplatte aufgebracht sind. So können die Elektrodenpaare an erwärmungs-unempfindlichen Stellen des Wafers angesetzt werden. Die Schaltplatte dient als Halterung der Elektrodenpaare und zugleich ist dort die Spannungsversorgung enthalten.

Die überwiegend aus Zirkoniumoxid bestehende Schicht des erfindungsgemäßen Greifers kann auch verschiedenste Zusatzstoffe enthalten. So können die mechanischen und elektrischen Eigenschaften geändert werden.

Besonders vorteilhaft hat sich bei einer zweckmäßigen Ausführungsform der Erfindung mit Yttriumoxid stabilisiertes Zirkoniumoxid als Isolationschicht erwiesen. Aber auch eine Isolierschicht aus reinem Zirkoniumoxid ist denkbar.

Eine Weiterbildung der Erfindung hat eine Halterung aus einer flexiblen Schaltplatte. So kann sich der Greifer der Form des Wafers anpassen.

Diese Schaltplatte kann zweckmäßigerweise eine gedruckte Schaltplatte sein, die in einem Arbeitsgang kostengünstig herstellbar ist.

Die Weiterbildung der Erfindung hat Elektrodenpaare, die eine runde, rechteckige oder fingerartige Form haben, und so nur wenig Fläche einnehmen.

Diese Elektrodenpaare können so aufgebaut werden, dass der eine Pol vom anderen Pol, z.B. kreisförmig, umschlossen wird.

Gegenüber herkömmlichen Bauformen, etwa als nebeneinander angeordnete Leiterbahnen wie in US 4,184,188, ist diese Geometrie sehr kompakt.

Zweckmäßigerweise ist der Greifer mit Gleichspannungen unter 900V betreibbar. Durch Reduzierung der Schichtdicken des Zirkoniumoxides und Optimierung der Geometrie sind sogar Spannungen bis unter 300 V denkbar. So ist die Aufheizung des Wafers minimal. Des weiteren werden so Verunreinigungen des Wafers durch angezogene Staubpartikel reduziert und die elektrische Schaltung zum Betrieb des Greifers wird wesentlich einfacher. Auch die Betriebskosten reduzieren sich durch geringeren Stromverbrauch.

Bei der Weiterbildung der Erfindung kann bei Lösen des Bauteils kurzzeitig eine Wechselspannung angelegt werden. So wird vermieden, dass sich der Wafer wegen eventuell vorhandener elektrostatischer Aufladung nicht löst.

Eine zweckmäßige Ausführungsform hat die Elektrodenpaare im Abstand voneinander so angeordnet, dass der Wafer am Rand gegriffen werden kann. So werden die Vorteile der kompakten Bauform der Elektrodenpaare optimal ausgenutzt. Durch das randseitige Greifen können Erwärmungen in empfindlichen Bereichen des Wafers noch weiter reduziert werden.

Zum Heben hat der Greifer nach einer weiteren Ausführungsform drei auf einer Kreisbahn angeordnete Elektrodenpaare, die idealerweise im 120° -Winkel um den Wafer angeordnet sind. So wird die Gewichtskraft des Wafers an die drei Elektrodenpaare gleich verteilt.

Ferner betrifft die Erfindung gemäß Anspruch 12 ein Verfahren zur Herstellung eines elektrostatischen Ein erfindungsgemäßer Greifer kann wie folgt hergestellt werden.

Dabei werden Elektrodenpaare auf eine flexible Schaltplatte gebracht. Dann wird eine Vermittlungsschicht auf die Elektroden gebracht. Dazu eignet sich z.B Indium, das in einem galvanischen Prozess in einer Schichtdicke von ca. 10 µm auch schon vorher auf die Elektroden aufgebracht werden kann. Auch eine Schicht Zink kann die Bindung der verschiedenen Materialien verbessern. Die Zirkoniumoxidschicht wird sodann auf die Indiumschicht gebracht. Auf der anderen Seite der Elektrode wird eine Isolierschicht aufgebracht. Dann werden die Schichten zusammengepresst, wodurch sie sich in einem Kaltverschweissungsvorgang miteinander verbinden. Diesem Vorgang kommt eine rauhe Oberfläche einer Zikoniumoxidscheibe zugute.

Je nach verwendetem Material für die Isolierschicht kann es, wie in einer Weiterbildung des Verfahrens vorgesehen, zweckmäßig sein, die Isolierschicht aufzukleben, oder eine schon mit Klebemittel beschichtete Isolierschicht zu verwenden.

Als Material für eine solche Isolierschicht eignet sich, wie in einer Ausführungsform des Verfahrens vorgesehen, insbesondere Aluminium(III)oxid. Dieses ist kostengünstig und wird standardmäßig als Isoliermaterial in der Halbleiterindustrie verwendet.

Die Elektrodenpaare können zuerst auf eine weitere flexible Schaltplatte aufgebracht werden, z.B. im Ätzverfahren. Die Elektrodenpaare werden dann mit der weiteren Schaltplatte auf die Schaltplatte gebracht. So kann die Herstellung des Greifers zwar nicht in einem Arbeitsgang erfolgen, das Verfahren bietet sich aber dann an, wenn wegen der Geometrie der Elektroden (z.B. sehr klein, Abstand der Elektroden sehr gering) eine Herstellung in einem Schritt technisch nicht machbar oder mit höherem Aufwand verbunden ist.

Im folgenden wird die Erfindung an einem Ausführungsbeispiel anhand der Zeichnungen Fig. 1 bis Fig.5 erläutert.
- Fig. 1: zeigt ein Elektrodenpaar in der Draufsicht;
- Fig. 2: zeigt ein Elektrodenpaar von der Rückseite;
- Fig. 3: zeigt die einzelnen Bauteile des elektrostatischen Halters in einer Explosionsansicht;
- Fig. 4: zeigt den fertigen Halter nach dem Pressvorgang;
- Fig. 5: zeigt eine Schnittansicht eines Greifelementes des Halters.

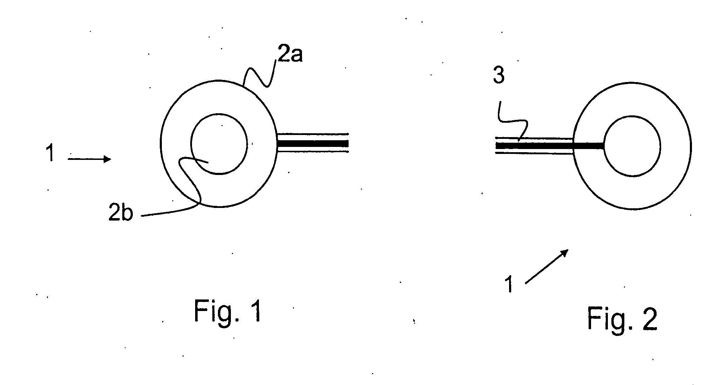

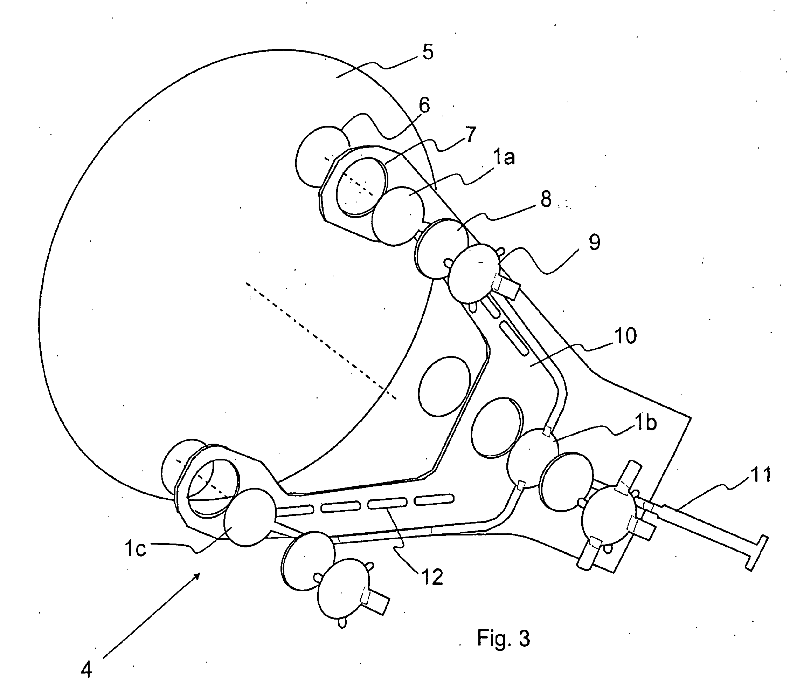

Die bipolaren Elektroden 1, die in Fig. 1 in der Draufsicht zu sehen sind, bestehen aus einem äußeren Ring 2 als eine Elektrode, der die andere Elektrode 2b umschließt. Die innere Elektrode 2b hat ihre Spannungsversorgung 3 auf der Oberseite der flexiblen, gedruckten Schaltplatte 10 (Fig. 3). Betrachtet man die Elektrode von oben (Fig. 2), ist die Spannungsversorgung 3 für die innere Elektrode zu erkennen. Zum Aufnehmen des Wafers 5 wird an die innere und die äußere Elektrode eine Gleichspannung angelegt. Das dabei entstehende elektrostatische Feld führt zur Anziehung des Wafers 5.

Der elektrostatische Halter 4, der in Fig 3 in einer Explosionsdarstellung zu sehen ist, besteht aus der flexiblen, gedruckten Schaltplatte 10, auf der die Leiterbahnen 11 für die Elektroden 1a-1c aufgedruckt sind. Hier sind die einzelnen Schichten, aus denen der Greifer besteht, wie vor dem Zusammenbringen dargestellt. Die einzelnen Schichten sind (außer den Elektrodenpaaren) nur beim oberen Greifelement mit Bezugszeichen versehen.

Vom Wafer 5 beginnend, sieht man davor eine Isolierschicht aus Zirkoniumoxid 6, die Schaltplatte 10, die Elektoden 1a-1c und einer weitere Isolierschicht 8 auf der Rückseite und ferner die Basisplatte 9.

Für die Leiterbahnen und die Elektroden nebst Isoliersicht sind in der Schaltplatte 10 Aussparungen 7, 12 vorgesehen. Die Elektroden 1a-1c enthalten die in Fig. 1 und 2 zu sehenden bipolaren Elektrodenpaare 2a,2b. Die Leiterbahnen 11 bestehen aus je zwei Leitungen zur Spannungsversorgung der Elektroden 1a-1c.

Die zuvor beschriebene Schichtstruktur aus einer Isolierschicht Zirkoniumoxid 6, den bipolaren Elektrodenpaaren 1a-1c, einer Isolierschicht auf der Rückseite 8 und einer Basisplatte 9 zur besseren Stabilität bildet ein erfindungsgemäßes elektrostatisches Greifelement 13a-13c.

Die Isolierschicht ist in diesem Ausführungsbeispiel mit einer Klebefolie (nicht dargestellt) versehen, wodurch sich die Bindung verbessert und Lufteinschlüsse weitgehend verhindert werden. Das Ausführungsbeispiel hat drei Elektrodenpaare bzw. Greifelemente, die im Winkel von 120° auf einer Kreisbahn angeordnet sind. So kann der Wafer ggf. an den Rändern gefasst werden.

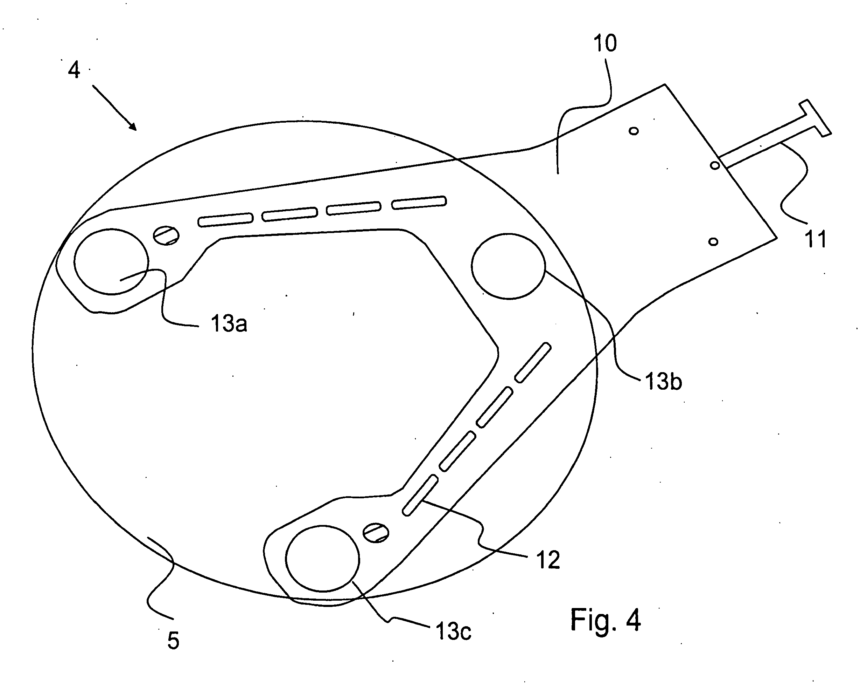

Nach dem Pressvorgang, bei dem der gesamte elektrostatische Greifer mit allen Greifelementen in einem Arbeitsvorgang zusammengefügt werden kann, sind die Schichten miteinander verbunden Fig 4. Die Greifelemente 13a-13c bestehen aus dem oben dargestellten Schichtverband. Ziel des Pressvorgangs ist, eine Kaltverschweissung herzustellen. Dabei kann z.B. Indium als Vermittlungsschicht (nicht dargestellt) zwischen der Zirkoniumoxidschicht 6 und den Elektroden 1a-1c verwendet werden, um eine optimale Verbindung zwischen Oxidschicht und Elektroden herzustellen. Die Stromversorgung erfolgt durch die nun in der Schaltplatte enthaltenen Leiterbahnen 11, deren Verlauf durch die vorher vorgesehenen Aussparungen 12 bestimmt wurde.

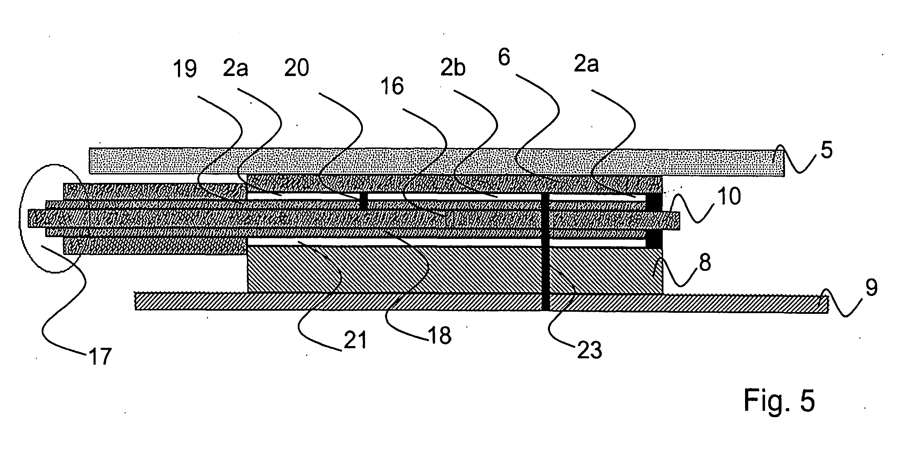

Fig. 5 zeigt eine Schnittansicht eines Greifelementes einschließlich eines gefassten Wafers. Oben ist der Wafer 5 zu sehen, darunter befindet sich die Isolierschicht aus Zirkoniumoxid 6, und dann kommt das bipolare Elektrodenpaar, bestehend aus innerer 2b und äußerer 2a Elektrode, die durch einen Ring aus isolierendem Material 20 getrennt sind. Danach kommt die Spannungsversorgung der äußeren Elektrode 15, die über eine leitende Schicht 19 erfolgt. Darunter befindet sich die flexible Schaltplatte 10 aus Kapton. Die Spannungsversorgung der inneren Elektrode erfolgt durch die leitende Schicht 18 darunter und eine Verbindung durch die Schaltplatte 16, eine darunter liegende leitende Schicht 21 dient als Weiterführung zu anderen Elektroden bzw. Greifelementen auf dem Greifer. Darunter befindet sich eine Isolierschicht aus Aluminium(III)oxid 8 und ganz unten eine stabile Basisplatte 9. Des weiteren ist bei diesem Ausführungsbeispiel noch ein Kanal 13 zur Einbringung von isolierendem Material vorgesehen. Solche Kanäle dienen der Einbringung von Isoliermaterial in die Kanäle zwischen den Elektroden. Bei der Spannungszuführung 17 ist die untere Schicht 18 für die innere, die obere Schicht 19 für die äußere Elektrode vorgesehen.

Die Schichtdicken und -materialien sind bei diesem Ausführungsbeispiel zwischen der Zirkoniumoxidschicht und der Isolierschicht wie folgt:
- Zwischen 80 und 250 µm Zirkoniumoxid 6.
- Ca. 10 µm Indium und 5 µm Nickel als Vermittlungsschicht zwischen Zirkoniumoxidschicht und Kupferelektrode.
- Ca. 17,5 µm Elektroden- und Versorgungsschichten aus Kupfer 14,15,21.
- Ca. 25 µm Schaltplatte aus Kapton oder Polyamid 10.
- Ca. 2,6 mm Isolierschicht aus Aluminiumoxid 8.
- Ca. 0,5 mm Basisplatte aus T 136 NiP 9.

Die innere Elektrode hat einen Durchmesser von 18 mm, die äußere einen Außendurchmesser von 37 mm. Nickel und Indiumschicht sind schon vorher auf den Kupferelektroden galvanisch aufgebracht.

Durch Anlegen einer Spannung wird der Wafer 5 durch elektrostatische Anziehung angezogen. Mit einer Spannung von 300 V betrieben, erreicht der elektrostatische Halter gemäß dem Ausführungsbeispiel eine Kraft von 6 N, die ausreichend ist, um einen Wafer anzuheben.

Der Greifer kann z.B. an einen Roboterarm montiert werden und zum Transport, Positionieren und zur Herbeiführung jeder denkbaren Lageänderung des Wafers eingesetzt werden.

## Patentansprüche

1. Greifvorrichtung (4) zum Aufnehmen, Halten und/oder Transportieren von Wafern (5), umfassend
- ein auf einer Schaltplatte (10) angeordnetes Greifelement (13a-13c), wobei das Greifelement
- ein mit einer Spannung beaufschlagbares bipolares Elektrodenpaar (1) beinhaltet, welches aus einer inneren (2b) und einer äußeren (2a) Elektrode besteht, die durch einen Ring aus isolierendem Material (20) getrennt sind, und wobei
- auf der Schaltplatte mindestens zwei Greifelemente (1a-1c) angeordnet sind, bei denen die bipolaren Elektrodenpaare (1) mit einer Isolierschicht (6) versehen sind, die überwiegend aus Zirkoniumoxid besteht
- und wobei die Elektrodenpaare (1a-1c) in einem solchen Abstand angebracht sind, dass der Wafer (5) an seinen Rändern anhebbar ist.

2. Greifvorrichtung nach Anspruch 1, **dadurch gekennzeichnet, dass** das Zirkoniumoxid mit Yttriumoxid stabilisiert ist.

3. Greifvorrichtung nach einem der vorgehenden Ansprüche, **dadurch gekennzeichnet, dass** die Halterung aus einer flexiblen Schaltplatte (10) besteht.

4. Greifvorrichtung nach einem der vorgehenden Ansprüche, **dadurch gekennzeichnet, dass** die Halterung aus einer flexiblen, gedruckten Schaltplatte (10) besteht.

5. Greifvorrichtung nach einem der vorgehenden Ansprüche, **dadurch gekennzeichnet, dass** die Elektrodenpaare (1) eine runde und/oder rechteckige und/oder fingerartige Form aufweisen.

6. Greifvorrichtung nach Anspruch 5, **dadurch gekennzeichnet, dass** jeweils der eine Pol (2) den anderen Pol umschließt

7. Greifvorrichtung nach einem der vorhergehenden Ansprüche, **dadurch gekennzeichnet, dass** der Greifer mit einer Gleichspannung von unter 900 V und/oder 600V und/oder 300 V betreibbar ist.

8. Greifvorrichtung nach einem der vorhergehenden Ansprüche, **dadurch gekennzeichnet, dass** bei Ablegen des Bauteiles durch Erdung kurz vorher eine Wechselspannung anlegbar ist.

9. Greifvorrichtung nach einem der vorhergehenden Ansprüche, **dadurch gekennzeichnet, dass** mindestens drei Elektrodenpaare (1a-1c) auf einer Kreisbahn angeordnet sind.

10. Greifvorrichtung nach Anspruch 9, **dadurch gekennzeichnet, dass** die drei Elektrodenpaare (1a-1c) etwa im 120°-Winkel um den Wafer angeordnet sind.

## Claims

1. Gripping device (4) for receiving, holding and/or transporting wafers (5), comprising
- a gripping element (13a-13c) disposed on a circuit board (10), wherein the gripping element
- contains a bipolar electrode pair (1) to which a voltage can be applied and which consists of an inner (2b) and an outer (2a) electrode which are separated by a ring of insulating material (20), and wherein
- at least two gripping elements (1a-1c) are arranged on the circuit board, in which gripping elements the bipolar electrode pairs (1) are provided with an insulating layer (6) which predominantly consists of zirconium oxide,
- and wherein the electrode pairs (1a-1c) are mounted in such a spaced relationship that the wafer (5) can be lifted at its edges.

2. Gripping device as claimed in claim 1, **characterised in that** the zirconium oxide is stabilized with yttrium oxide.

3. Gripping device as claimed in any one of the preceding claims, **characterised in that** the holder consists of a flexible circuit board (10).

4. Gripping device as claimed in any one of the preceding claims, **characterised in that** the holder consists of a flexible printed circuit board (10).

5. Gripping device as claimed in any one of the preceding claims, **characterised in that** the electrode pairs (1) are round and/or rectangular and/or finger-like in shape.

6. Gripping device as claimed in claim 5, **characterised in that** in each case one pole (2) surrounds the other pole.

7. Gripping device as claimed in any one of the preceding claims, **characterised in that** the gripper can be operated with a direct voltage of below 900 V and/or 600 V and/or 300 V.

8. Gripping device as claimed in any one of the preceding claims, **characterised in that** when a component is being put down, an alternating voltage can be applied shortly beforehand by grounding.

9. Gripping device as claimed in any one of the preceding claims, **characterised in that** at least three electrode pairs (1a-1c) are disposed on a circular path.

10. Gripping device as claimed in claim 9, **characterised in that** the three electrode pairs (1a-1c) are disposed at approximately a 120° angle around the wafer.

## Revendications

1. Dispositif de préhension (4) pour la saisie, le maintien et/ou le transport de tranches (5), comprenant :
- un élément de préhension (13a-13c) disposé sur une plaquette (10), ledit élément de préhension contenant :
- une paire d'électrodes (1) bipolaire pouvant être soumise à une tension, laquelle se compose d'une électrode intérieure (2b) et d'une électrode extérieure (2a), séparées par une bague en matériau isolant (20), et
- au moins deux éléments de préhension (1a-1c) étant disposés sur la plaquette, les paires d'électrodes (1) bipolaires étant pourvues d'une couche isolante (6) majoritairement constituée d'oxyde de zirconium,
- les paires d'électrodes (1a-1c) étant disposées avec un espacement tel que la tranche (5) peut être soulevée sur ses bords.

2. Dispositif de préhension selon la revendication 1, **caractérisé en ce que** l'oxyde de zirconium est stabilisé avec de l'oxyde d'yttrium.

3. Dispositif de préhension selon l'une des revendications précédentes, **caractérisé en ce que** le support consiste en une plaquette (10) flexible.

4. Dispositif de préhension selon l'une des revendications précédentes, **caractérisé en ce que** le support consiste en une plaquette imprimée (10) flexible.

5. Dispositif de préhension selon l'une des revendications précédentes, **caractérisé en ce que** les paires d'électrodes (1) présentent une forme circulaire et/ou rectangulaire et/ou sont en forme de doigt.

6. Dispositif de préhension selon la revendication 5, **caractérisé en ce que** chaque premier pôle (2) entoure l'autre pôle correspondant.

7. Dispositif de préhension selon l'une des revendications précédentes, **caractérisé en ce que** le préhenseur peut être mis en service sous une tension continue inférieure à 900 V et/ou à 600 V et/ou à 300 V.

8. Dispositif de préhension selon l'une des revendications précédentes, **caractérisé en ce qu'**à la dépose du composant, une tension alternative est applicable par mise à la terre peu de temps auparavant.

9. Dispositif de préhension selon l'une des revendications précédentes, **caractérisé en ce qu'**au moins trois paires d'électrodes (1a-1c) sont disposées sur un chemin circulaire.

10. Dispositif de préhension selon la revendication 9, **caractérisé en ce que** trois paires d'électrodes (1a-1c) sont disposées sensiblement suivant un angle de 120° autour de la tranche.
